# EUROPEAN PATENT SPECIFICATION

(11) **EP 2 743 999 B1**
(45) Date of publication and mention of the grant of the patent: **04.09.2019**
(21) Application number: 13176341.9
(22) Date of filing: 12.07.2013
(51) Int. Cl.: H01L 33/50

(54) **Light emitting device package including phosphor film, and method of manufacturing the same.**
Vorrichtungsbaugruppe mit einer Leuchtstoffschicht für eine lichtemittierende Vorrichtung, und Herstellungsverfahren dafür.
Module de dispositif électroluminescent comprenant un film de phosphore et son procédé de fabrication.

(30) Priority: 14.12.2012 KR 20120146185
(43) Date of publication of application: 18.06.2014
(73) Proprietor: LG Electronics, Inc., Seoul 150-721 (KR)
(72) Inventor: Park, Daehyun, 137-724 Seoul (KR); Hong, Gunyong, Geumcheon-gu Seoul, 153-802 (KR); Kim, Jeseok, Gwanak-gu Seoul 151-851 (KR); Kang, Dongwon, Seoul (KR)
(74) Representative: Vossius & Partner Patentanwälte Rechtsanwälte mbB

(56) References cited:
- WO-A1-2009/119034
- WO-A1-2011/097137
- US-A1- 2004 257 797
- US-A1- 2010 155 666

## Description

The present invention relates to a light emitting device package, and more particularly to a light emitting device package including a phosphor film, a method of manufacturing the same.

A light Emitting Diode (LED) is a sort of a light emitting device that is fabricated using semiconductor manufacturing processes and entered into practical use in the late 1960s after light emission from a semiconductor device upon voltage application was observed.

Research and development to improve LED efficiency have continued. In particular, interest in LEDs having optical properties sufficient for replacement of conventional light sources is increasing. In addition to increased research into LEDs, research into LED packages and lighting apparatuses using the same are actively underway.

In addition, point light sources and small optical devices have been extensively used in various industrial fields including indication, signaling, display, lighting, biochip, communication, cellular phones, Liquid Crystal Display (LCD), automobile fields, and the like, and continuous growth thereof is expected.

Although an LED package has conventionally been configured in such a way that a mixture of a phosphor and an encapsulation material is applied to a light emitting device, this LED package may be susceptible to efficiency deterioration due to deterioration and discoloration of resin and poor temperature reliability of the phosphor because high power light sources have been increasingly used in recent years for enhancement in the performance of LEDs.

WO 2009/119034 A1 relates to a blue LED that is a semiconductor light-emitting device and that emits blue light as primary light having a peak wavelength in a visible region and a phosphor plate that is a wavelength converter and that converts a portion of the blue light emitted from the blue LED into yellow light as secondary light having a longer peak wavelength in the visible region than the peak wavelength and emits the yellow light in combination with a remainder of the blue light left unconverted.

WO2011/097137 A1 relates to a ceramic composite laminate including a wavelength-converting layer and a non-emissive layer, wherein the ceramic composite laminate has a wavelength conversion efficiency (WCE) of at least 0.650.

US 2004/257797 A1 relates to a light emitting device having a light emitting element portion that radiates light with a predetermined wavelength, and a wavelength conversion portion that surrounds a phosphor to be excited by the light with the predetermined wavelength with a transparent and non-moisture permeability material in the form of laminae.

US 2010/155666 A1 relates to a phosphor composite material which can be fired at low temperatures and enables to obtain a phosphor composite member which is excellent in weather resistance and reduced in deterioration after long use.

Accordingly, the present invention is directed to a light emitting device package including a phosphor film, and a method of manufacturing the same that substantially obviate one or more problems due to limitations and disadvantages of the related art.

One object of the present invention is to provide a light emitting device package including a phosphor film, which enables cheaper and easier fabrication of a large-area plate upon fabrication of a plate type phosphor, a method of manufacturing the light emitting device package, and a lighting apparatus using the light emitting device package.

Another object of the present invention is to provide a light emitting device package including a phosphor film capable of enhancing light emission efficiency, and a method of manufacturing the light emitting device package.

To achieve these objects and other advantages and in accordance with the purpose of the invention, as embodied and broadly described herein, a method of manufacturing a light emitting device package according to claim 1 is provided.

In accordance with another aspect of the present invention, a light emitting device package according to claim 9 is provided.

It is to be understood that both the foregoing general description and the following detailed description of the present invention are exemplary and explanatory and are intended to provide further explanation of the invention as claimed.

The accompanying drawings, which are included to provide a further understanding of the invention and are incorporated in and constitute a part of this application, illustrate embodiment(s) of the invention and together with the description serve to explain the principle of the invention. In the drawings:
FIG. 1 illustrates sectional views of sequential operations of one exemplary method not according to the claimed invention of manufacturing a phosphor film provided in a light emitting device package;
FIG. 2 illustrates sectional views of sequential operations of a method according to the claimed invention of manufacturing the phosphor film provided in the light emitting device package;
FIG. 3 illustrates sectional views of sequential operations of a further exemplary method not according to the claimed invention of manufacturing the phosphor film provided in the light emitting device package;
FIG. 4 illustrates an SEM image showing one example of the phosphor film provided in the light emitting device package;
FIG. 5 illustrates SEM images showing other examples of the phosphor film provided in the light emitting device package;
FIG. 6 illustrates a schematic view showing one example of the light emitting device package including the phosphor film;
FIG. 7 illustrates schematic views showing light emission of the light emitting device package including the phosphor film;
FIG. 8 illustrates schematic views showing another example of the light emitting device package including the phosphor film;
FIG. 9 illustrates a schematic view explaining light extraction efficiency depending on the aspect ratio of a pattern provided in a glass film of the light emitting device package including the phosphor film;
FIG. 10 illustrates views showing optical simulation results of the light emitting device package including the phosphor film;
FIG. 11 illustrates a perspective view showing one example of a lighting apparatus including the light emitting device package; and
FIG. 12 illustrates an exploded perspective view showing another example of the lighting apparatus including the light emitting device package.
Hereinafter, the embodiments of the present invention will be described in detail with reference to the accompanying drawings.

Specific embodiments of the present invention as well as embodiments not according to the claimed invention will be described below in detail with reference to the annexed drawings and various modifications and alterations thereof are possible. However, the present invention should not be limited to the disclosed specific embodiments, and various modifications, additions, and substitutions to the specific elements are possible, without departing from the scope and spirit of the invention as disclosed in the accompanying claims.

It will be understood that, when an element such as a layer, region or substrate is referred to as being "on" another element, it can be directly on the other element or intervening elements may also be present.

In addition, it will be understood that, although the terms first, second, etc. may be used herein to describe various elements, components, regions, layers and/or sections, these elements, components, regions, layers and/or sections should not be limited by these terms.

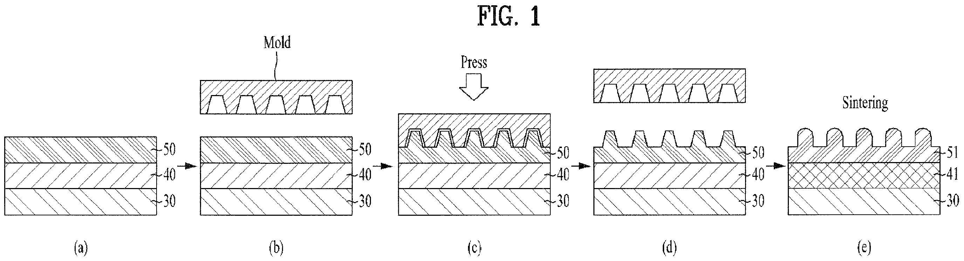

FIG. 1 illustrates sectional views of sequential operations of one exemplary not according to the claimed invention of manufacturing a phosphor film provided in a light emitting device package.

Referring to FIG. 1(a), a phosphor film green sheet 40 and a glass film green sheet 50 are formed in sequence over a first surface (upper surface) of a support substrate 30.

More specifically, first, the phosphor film green sheet 40 may be attached to the support substrate 30.

The support substrate 30 serves to support the phosphor film green sheet 40. The support substrate 30 may be formed of any transparent material capable of withstanding sintering. For example, the support substrate 30 may be a glass substrate.

Attachment of the phosphor film green sheet 40 to the support substrate 30 may be realized, for example, by lamination.

In this case, the phosphor film green sheet 40 may be formed by coating a film with a mixture of at least one of a glass powder, a phosphor powder, and an organic binder. The film may be a polyethylene terephthalate (PET) film.

Here, the glass powder constructs a matrix. Of course, any other materials may be used so long as they have high transmittance and are capable of retaining a phosphor therein without reduction of transmittance.

For example, the glass powder may include at least one selected from the group of SiO₂-B₂O₃-RO based glass (wherein R is Mg, Ca, Sr or Ba), SiO₂-B₂O₃ based glass, SiO₂-B₂O₃-R₂O based glass (wherein R is Li, Na or K), SiO₂-B₂O₃- Al₂O₃ based glass, SiO₂-B₂O₃- ZnO based glass, and ZnO- B₂O₃ based glass.

The phosphor powder may include a YAG based phosphor, silicate based phosphor, sulfide based phosphor, nitride based phosphor, or mixtures thereof.

For example, a green light emitting phosphor powder may include Ba₂SiO₄:Eu²⁺, Sr₂SiO₄:Eu²⁺, SrAl₂O₄:Eu²⁺, Sr₄Al₁₄O₂₅:Eu²⁺, SrGa₂S₄:Eu²⁺, CaGa₂S₄:Eu²⁺, SrSi₂AlO₂-N₃:Eu²⁺, (Ca,Sr,Ba)Si₂N₂O₂:Eu²⁺, YSiO₂N:Tb³⁺, Y₂Si₃O₃N₄:Tb³⁺, Gd₂Si₃O₃N₄.Tb³⁺, or mixtures thereof.

For example, a red light emitting phosphor powder may include Sr₃SiO₅:Eu²⁺, SrS:Eu²⁺, CaS:Eu²⁺, Sr₂Si₅N₈:Eu²⁺, Ca₂Si₅N₈:Eu²⁺, CaAlSiN₃, (Ca,Sr,Ba)₂Si₅N₈:Eu²⁺, LaSi₃N₅:Eu²⁺, Sr-α-SiAlON, or mixtures thereof.

The organic binder will be burned out during sintering that will be described hereinafter, and thus substantially does not remain in a final product. The organic binder may be an acryl based resin, a vinyl based resin, or a silicone based resin.

For example, the organic binder may be a polyvinyl butyral resin, or methacrylate resin. Meanwhile, the organic binder may be liquid phase at room temperature.

Alternatively, a dispersing agent may be additionally mixed to the mixture of the glass powder, the phosphor powder, the organic binder to prepare a coating for the manufacture of a green sheet. In this case, an anionic dispersing agent and an amphoteric dispersing agent may be mainly used. For example, an acrylic or acetate dispersing agent may be used.

Accordingly, the phosphor film green sheet 40 manufactured as described above includes an organic resin and an inorganic solid. The organic resin includes an organic binder. In addition, the organic resin may further include a dispersing agent. In addition, the inorganic solid consists of a glass component constructing a matrix and a phosphor component.

In one example, if a green sheet is formed of an organic resin that consists of an organic binder and a dispersing agent and an inorganic solid that consists of a glass component and a phosphor component, the composition range of the green sheet may include an organic resin in a range of 12 wt% to 25 wt% and an inorganic solid in a range of 75 wt% to 88 wt%.

In this case, the composition range of the organic resin may include the organic binder in a range of 99.2 wt% to 99.9 wt% and the dispersing agent in a range of 0.1 wt% to 0.8 wt%.

In addition, the composition range of the inorganic solid may include the glass component in a range of 60 wt% to 90 wt% and the phosphor component in a range of 10 wt% to 40 wt%.

Next, the glass film green sheet 50 may be attached to the phosphor film green sheet 40.

The glass film green sheet 50 may be manufactured by coating a film with a mixture of a glass powder and an organic binder. Alternatively, a dispersing agent may be additionally mixed with the mixture of the glass powder and the organic binder, to prepare a coating for the manufacture of a green sheet.

As such, the composition of the glass film green sheet 50 may include an organic resin and an inorganic solid. For example, the organic resin may include an organic binder and a dispersing agent, and the inorganic solid may include a glass component.

The glass film green sheet 50 manufactured as described above may be attached to the phosphor film green sheet 40.

As occasion demands, the glass film green sheet 50 may be directly coated on the phosphor film green sheet 40.

Alternatively, prior to attaching the glass film green sheet 50 to the phosphor film green sheet 40, the phosphor film green sheet 40 may be subjected to sintering, to form a phosphor film 41. In this case, the glass film green sheet 50 may be attached to the sintered phosphor film 41. Additionally, the glass film green sheet 50 may be directly coated on the phosphor film 41.

The phosphor film green sheet 40 and the glass film green sheet 50 are flexible, and thus may be easily patterned into various shapes via mold pressing that will be described hereinafter.

Referring to FIGs. 1(b) to 1(d), the support substrate 30, over which the phosphor film green sheet 40 and the glass film green sheet 50 have been formed, is subjected to mold pressing, such that the top of the glass film green sheet 50 is patterned.

For example, once the phosphor film green sheet 40 and the glass film green sheet 50 have been formed on the support substrate 30, pressure may be applied to the glass film green sheet 50 using a mold to pattern the top of the glass film green sheet 50.

In this case, various shapes of molds may be used. For example, a rounded mold, a wedged mold, or the like may be prepared.

As such, a pattern having a shape corresponding to the shape of the mold may be provided on the glass film green sheet 50.

The pattern provided on the glass film green sheet 50 may include a hole pattern, a line pattern, a recessed pattern, or a ridged pattern. Alternatively, the pattern may be a micro lens shaped pattern.

The pattern may have a slope having an inclination with respect to a plane of the support substrate 30.

Referring to FIG. 1(e), the phosphor film green sheet 40 and the patterned glass film green sheet 50 may be subjected to sintering, to form the phosphor film 41 and a patterned glass film 51.

Upon sintering of the phosphor film green sheet 40 and the patterned glass film green sheet 50, the organic resin included in the phosphor film green sheet 40 and the glass film green sheet 50 may be burned out, whereby the phosphor film 41 and the patterned glass film 51 may be formed.

In this case, the sintering temperature may be in a range of 500°C to 620°C. If the sintering temperature is less than 500°C, bubbles in the green sheet are not removed, which causes deterioration of transmittance. Likewise, if the sintering temperature exceeds 620°C, bubbles are generated in the green sheet, which causes deterioration of transmittance.

Sintering may cause deformation of the pattern provided on the glass film green sheet 50. For example, if the pattern has an angled shape, the pattern may be deformed into a rounded shape via sintering. This rounded deformation may result in a lens shaped pattern, which may achieve enhanced light extraction efficiency.

Although not shown, a lens unit 60 may be additionally formed a second surface (lower surface) of the support substrate 30. For example, polymer beads or a resin may be applied to the bottom of the support substrate 30, to form the lens unit.

In this way, according to the present invention, a patterned phosphor film may be easily manufactured using a green sheet, and moreover a large-area plate-shaped phosphor film may be manufactured.

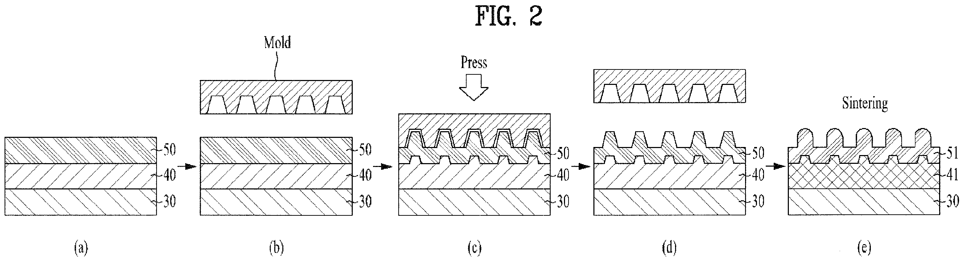

FIG. 2 illustrates sectional views of sequential operations of a method according to the claimed invention of manufacturing the phosphor film provided in the light emitting device package.

Referring to FIG. 2(a), the phosphor film green sheet 40 and the glass film green sheet 50 are formed in sequence over the support substrate 30. This formation is equal to the above description of FIG. 1(a), and thus a detailed description thereof will be omitted hereinafter.

Referring to FIGs. 2(b) to 2(d), the support substrate 30, over which the phosphor film green sheet 40 and the glass film green sheet 50 have been formed, is subjected to mold pressing, such that the top of the glass film green sheet 50 is patterned. In this case, the mold pressing is implemented to ensure that the top of the phosphor film green sheet 40 is also patterned.

That is, the phosphor film green sheet 40 as well as the glass film green sheet 50 may be patterned by adjusting the strength and elongation of the phosphor film green sheet 40. In addition, the phosphor film green sheet 40 as well as the glass film green sheet 50 may be patterned by adjusting the pressure of mold pressing.

Referring to FIG. 2(e), the patterned phosphor film green sheet 40 and the patterned glass film green sheet 50 are subjected to sintering, to form the patterned phosphor film 41 and the patterned glass film 51. In this case, the sintering is equal to the above description of FIG. 1(e).

Although not shown, the lens unit 60 may be additionally formed at the bottom of the support substrate 30. For example, polymer beads or a resin may be applied to the bottom of the support substrate 30, to form the lens unit.

As described above, the patterned glass film 51 may be formed via mold pressing. In addition, the top of the phosphor film 41 may be patterned. Patterning the top of the phosphor film 41 may increase a phosphor surface area, resulting in enhancement of light extraction efficiency.

Hereinafter, a repeated description of the same configuration as that of FIG. 1 will be omitted.

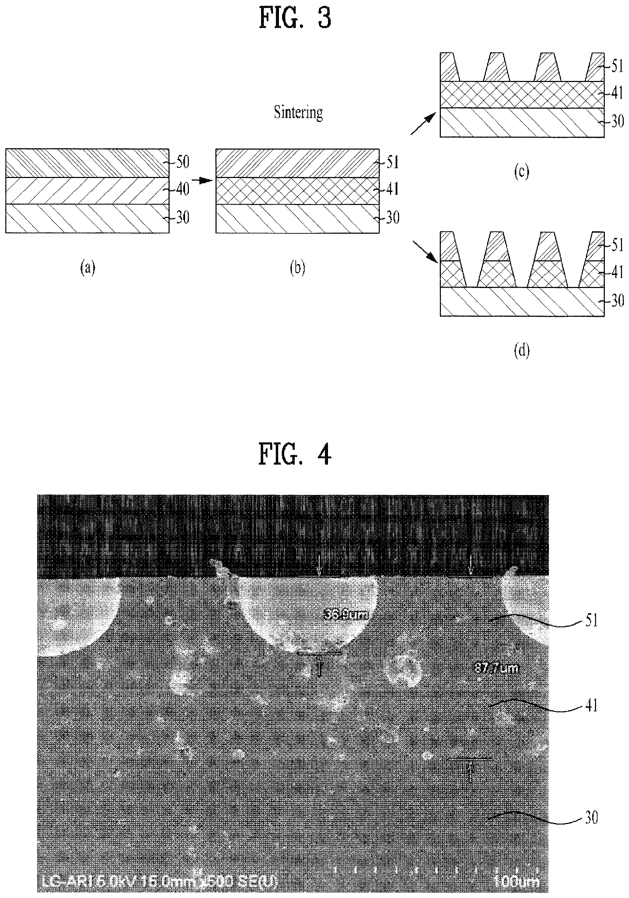

FIG. 3 illustrates sectional views of sequential operations of a further exemplary method not according to the claimed invention of manufacturing the phosphor film provided in the light emitting device package.

Referring to FIG. 3(a), the phosphor film green sheet 40 and the glass film green sheet 50 are formed in sequence over the support substrate 30. This is equal to the above description of FIG. 1(a).

Referring to FIG. 3(b), the phosphor film green sheet 40 and the glass film green sheet 50 are subjected to sintering, to form the phosphor film 41 and the glass film 51. In this case, the sintering temperature may be in a range of 500°C to 620°C.

Referring to FIG. 3(c), the top of the sintered glass film 51 may be patterned.

Patterning the top of the sintered glass film 51 may include forming a resist pattern (not shown) on the sintered glass film 51, etching the glass film 51 exposed through the resist pattern, and removing the resist pattern.

For example, after a resist layer (not shown) is formed on the glass film 51 via various methods, such as spin coating, and the like, the formed resist layer is patterned to form the resist pattern.

Next, the resist layer may be patterned via lithography. The resist pattern may be any one of various patterns, such as a hole pattern, and the like.

Thereafter, the glass film exposed through the resist pattern may be subjected to chemical etching, and then the resist pattern may be removed.

Referring to FIG. 3(d), after the phosphor film green sheet 40 and the glass film green sheet 50 are subjected to sintering to form the phosphor film 41 and the glass film 51, the sintered phosphor film 41 as well as the sintered glass film 51 may be patterned.

That is, patterning the sintered phosphor film 41 and the sintered glass film 51 may include forming a resist pattern on the sintered glass film 51, etching the glass film 51 exposed through the resist pattern, etching the phosphor film 41 exposed via etching of the glass film 51, and removing the resist pattern.

Although not shown, the lens unit 60 may be additionally formed at the bottom of the support substrate 30. For example, polymer beads or a resin may be applied to the bottom of the support substrate 30, to form the lens unit.

Hereinafter, a repeated description of the same configuration as that of FIG. 1 or FIG. 2 will be omitted.

FIG. 4 illustrates an SEM image showing one example of the phosphor film manufactured by the above described method.

Referring to FIG. 4, after the phosphor film green sheet and the glass film green sheet, formed over the glass support substrate 30, are sintered at a temperature of 550°C to form the phosphor film 41 and the glass film 51, the top of the glass film 51 is patterned via photoresist and chemical etching. As shown, it will be appreciated that a hole pattern is provided on the glass film 51.

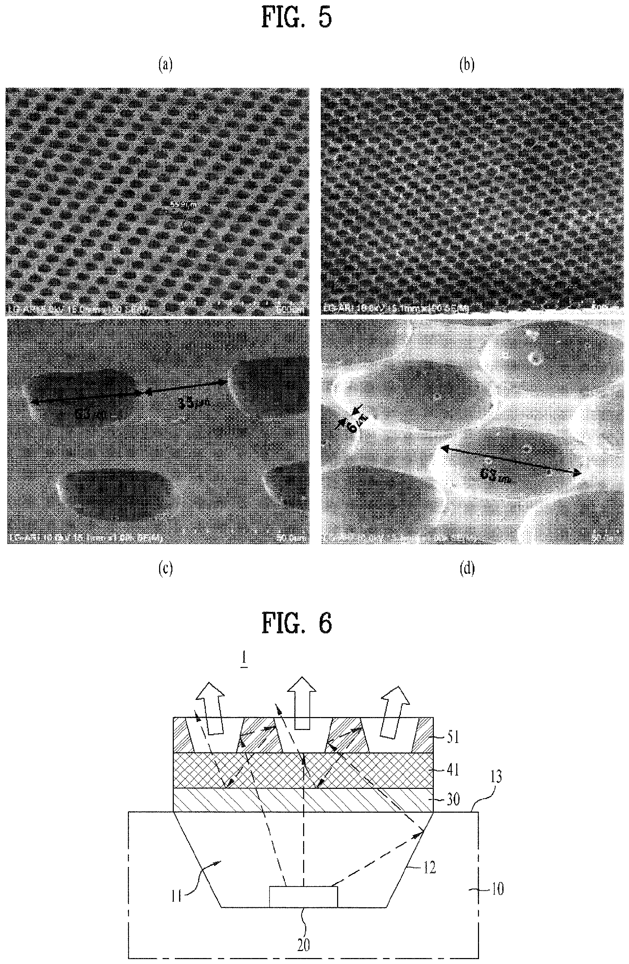

FIG. 5 illustrates SEM images showing other examples of the phosphor film manufactured by the above described method.

Referring to FIGs. 5(a) to 5(d), it will be appreciated that patterns having variously adjusted widths and distances may be manufactured.

As such, patterns having widths or distances of several micrometers to several hundred micrometers may be manufactured and applied in various ways so as to conform to target optical designs depending on the content and kind of phosphor.

FIG. 6 is a schematic view showing one example of a light emitting device package including the phosphor film as described above.

Referring to FIG. 6, the light emitting device package 1 includes a package body 10, a light emitting device 20, the support substrate 30, the phosphor film 41, and the patterned glass film 51.

That is, as the support substrate 30, over which the phosphor film 41 and the glass film 51 have been formed as described above, is mounted on the package body 10 equipped with the light emitting device 20, the light emitting device package 1 is completed.

The package body 10 may include a mounting portion 11 in which the light emitting device 20 is mounted. The package body 10 may be provided with a lead (not shown) electrically connected to the light emitting device 20 mounted in the mounting portion 11 and a heat sink (not shown), but a description thereof will be omitted.

As shown, the mounting portion 11 may take the form of a recess indented in an upper surface of the package body 10. As such, a slope 12 may be defined around a surface on which the light emitting device 20 is disposed. The slope 12 may serve as a reflective surface.

In addition, the mounting portion 11 may be filled with a filler (not shown). The filler may include silicon gel or epoxy resin. The filler serves to protect and seal the light emitting device 20 that will be described hereinafter.

The light emitting device 20 is mounted in the mounting portion 11. Although a variety of light emitting devices may be used as the light emitting device 20, in one example, the light emitting device 20 may be a Light Emitting Diode (LED).

The support substrate 30 may be located over the mounting portion 11 in which the light emitting device 20 is mounted. The support substrate 30 may be a transparent substrate to outwardly transmit light emitted from the light emitting device 20. Thus, the support substrate 30 may be the support substrate 30 as described above with reference to FIGs. 1 to 3.

The phosphor film 41 may be located on the support substrate 30. The phosphor film 41 may convert the wavelength of at least a part of light emitted from the light emitting device 20.

That is, the phosphor film 41 absorbs light emitted from the light emitting device 20 to discharge wavelength converted light. As such, the light emitting device package 1 may discharge mixed light of light emitted from the light emitting device 20 and light having passed through the phosphor film 41.

The patterned glass film 51 may be located on the phosphor film 41.

The phosphor film and the patterned glass film may be manufactured using the phosphor film green sheet and the glass film green sheet as described above with reference to FIGs. 1 to 3. For example, the phosphor film and the patterned glass film may be manufactured by sintering the phosphor film green sheet and the patterned glass film green sheet.

In addition, configurations of the phosphor film 41 and the glass film 51 are not limited to the above description, and all of various patterns that may be acquired via the method of FIGs. 1 to 3 may be applied. For example, both the phosphor film 41 and the glass film 51 may have patterned configurations.

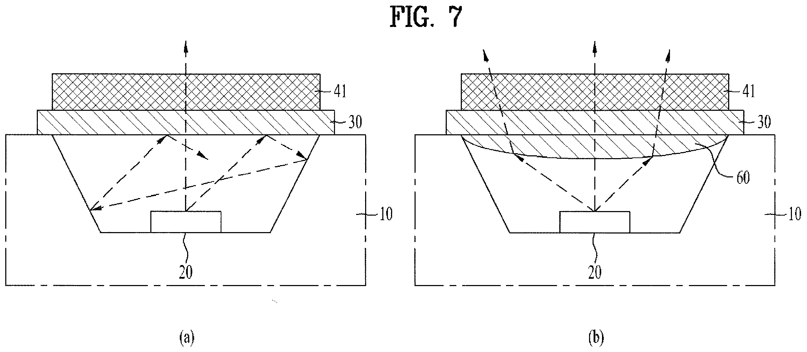

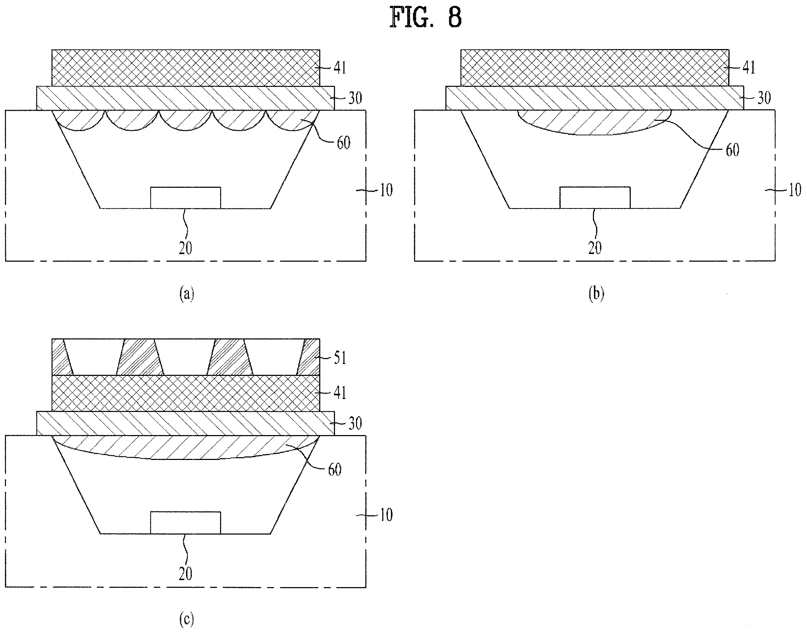

Meanwhile, a lens unit (see FIGs. 7 and 8) may be further located at the bottom of the support substrate 30. The lens unit may be formed on at least a part of the bottom of the support substrate 30, and may take the form of a pattern.

In the drawings, the arrows represent that light emitted from the light emitting device 20 is refracted by the patterned glass film 51. It will be appreciated that light conversion efficiency of the phosphor film 41 may be increased as the refracted light again passes through the phosphor film 41.

That is, a slope having an inclination with respect to a surface of the support substrate 30 or a pattern having a lens-shaped cross section may cause refraction of light emitted from the light emitting device 20, which may increase light extraction efficiency as well as light conversion efficiency.

Hereinafter, enhancement of light extraction efficiency in the case in which a lens unit is additionally located at the bottom of the support substrate 30 will be described.

FIGs. 7(a) and 7(b) are schematic views showing light emission of the light emitting device package.

In the light emitting device package of FIGs. 7(a) and 7(b), the support substrate 30 and the phosphor film 41 are located on the package body 10 equipped with the light emitting device 20. FIG. 7(a) shows the case in which the lens unit is not located at the bottom of the support substrate 30, and FIG. 7(b) shows the case in which the lens unit 60 is located at the bottom of the support substrate 30.

Referring to FIG. 7(a), the shown arrows represent that a part of light emitted from the light emitting device 20 is scattered by an interface of the support substrate 30, thereby being dissipated within the package body 10.

Referring to FIG. 7(b), the shown arrows represent that light emitted from the light emitting device 20 is directed outward by the lens unit 60 located at the bottom of the support substrate 30.

That is, it will be appreciated that the lens unit 60 may minimize dissipation of light emitted from the light emitting device 20 within the package body 10 and may enhance light extraction efficiency, differently from FIG. 7(a).

FIGs. 8(a) to 8(c) are schematic views showing other examples of the light emitting device package.

Referring to FIGs. 8(a) to 8(c), the light emitting device package is configured in such a way that the support substrate 30 and the phosphor film 41 are located over the package body 10 equipped with the light emitting device 20 and the lens unit 60 having various shapes is located at the bottom of the support substrate 30.

FIG. 8(a) shows one example in which the lens unit 60 including a plurality of lenses having the same shape is arranged at the bottom of the support substrate 30, and FIG. 8(b) shows another example in which the lens unit 60 including a single lens is located at the center of the support substrate 30.

Referring to FIG. 8(c), the lens unit 60 including a single lens is located at the center of the support substrate 30, and the patterned glass film 51 is located on the phosphor film 41.

The various configurations of the lens unit 60 may be applied in various ways according to optical designs.

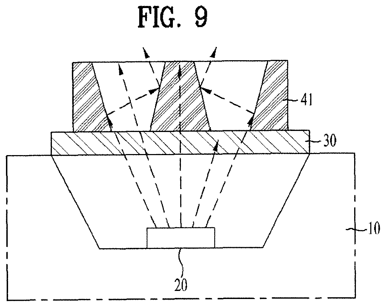

FIG. 9 is a schematic view of the light emitting device package explaining light extraction efficiency depending on the aspect ratio of a pattern of the glass film.

Referring to FIG. 9, the light emitting device package is configured in such a way that the support substrate 30 and the patterned phosphor film 41 are located over the package body 10 equipped with the light emitting device 20.

In this case, the aspect ratio of a pattern provided on the phosphor film 41 may be increased to achieve the reflective phosphor film 41. To this end, the aspect ratio of the pattern of the phosphor film 41 may be equal to or greater than 2:1.

If the aspect ratio of the pattern of the phosphor film 41 is less than 2:1, the pattern may cause insufficient reflection. Accordingly, the aspect ratio of the pattern of the phosphor film 41 may be in a range of 2:1 to 6:1.

As occasion demands, a patterned glass film (not shown) may be further provided on the patterned phosphor film 41 to correspond to the pattern of the phosphor film 41. In this case, the aspect ratio may be adjusted in consideration of all the patterns provided on the glass film and the phosphor film.

In this way, owing to the aspect ratio of the pattern of the phosphor film 41 in a range of 2:1 to 6:1, a reflective phosphor film having higher efficiency than an unpatterned phosphor film (transmissive phosphor film) may be manufactured.

Hereinafter, increase in the extraction efficiency of light from the reflective phosphor film will be described based on optical simulation results.

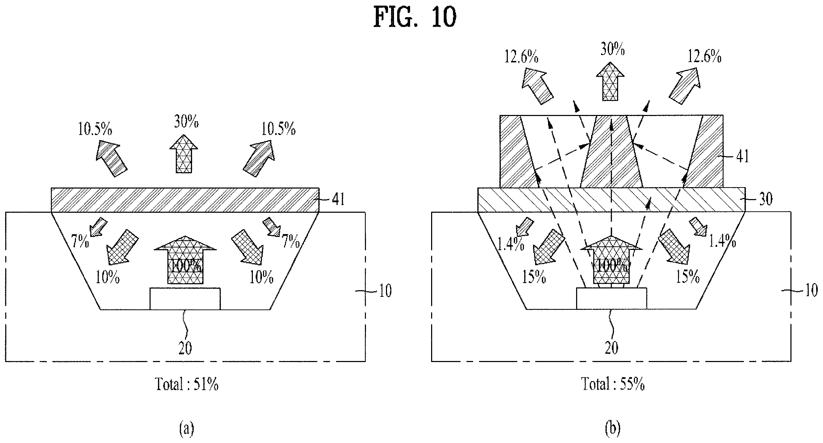

FIG. 10 illustrates views showing optical simulation results of the light emitting device package including the phosphor film.

Referring to FIG. 10(a), the light emitting device package includes the unpatterned phosphor film 41 over the package body 10 equipped with the light emitting device 20. Referring to FIG. 10(b), the light emitting device package includes the patterned phosphor film 41 and the support substrate 30 over the package body 10 equipped with the light emitting device 20. In this case, the light emitting device 20 is a blue light emitting diode.

In the light emitting device package of FIG. 10(a), a part of light emitted from the light emitting device 20 is inwardly scattered and dissipated, and a part of the light is discharged outward by passing through the phosphor film 41.

More specifically, the phosphor film 41 transmits 30% of blue light emitted from the light emitting device 20, backwardly reflects 20% of the light into the package, and absorbs 50% of the light.

In this case, conversion efficiency of the light absorbed by the phosphor film 41 into visible light is 70%. Thus, a value obtained by multiplying the absorption efficiency of 50% of the phosphor film 41 by the visible light conversion efficiency of 70% represents converted visible light of 35%.

In addition, since the backward reflectance of converted visible light into the package is 40%, finally outwardly transmitted visible light is 21%.

Accordingly, the sum of the blue light of 30% having passed through the phosphor film 41 and the outwardly discharged visible light of 21% converted from the blue light by the phosphor film 41 is finally transmitted light of 51%.

Likewise in the light emitting device package of FIG. 10(b), a part of light emitted from the light emitting device 20 is inwardly scattered and dissipated, and a part of the light is discharged outward by passing through the phosphor film 41.

More specifically, the phosphor film 41 transmits 30% of blue light emitted from the light emitting device 20, backwardly reflects 30% of the light into the package, and absorbs 40% of the light.

In this case, conversion efficiency of the light absorbed by the phosphor film 41 into visible light is 70%. Thus, a value obtained by multiplying the absorption efficiency of 40% of the phosphor film 41 by the visible light conversion efficiency of 70% represents converted visible light of 28%.

In addition, since the backward reflectance of converted visible light into the package is 10%, finally outwardly transmitted visible light is approximately 25%. Accordingly, the sum of the blue light of 30% having passed through the phosphor film 41 and the outwardly discharged visible light of 25% converted from the blue light by the phosphor film 41 is finally transmitted light of 55%.

To achieve patterning of the reflective phosphor film of FIG. 10(b), a part of the phosphor film is etched, which results in reduction of the absorption efficiency of the phosphor film. That is, the phosphor film has a light absorption efficiency of 40%, which is less than the light absorption efficiency of 50% of the transmissive phosphor film of FIG. 10(a).

It is noted that the pattern of the reflective phosphor film increases reflection and outward discharge of light absorbed by the reflective phosphor film. Accordingly, the backward reflectance of converted visible light by the reflective phosphor film is 10% which is considerably less than 40% of the backward reflectance of converted visible light by the transmissive phosphor film.

Accordingly, it will be appreciated that the case of using the reflective phosphor film may achieve approximately 10% increased light transmission efficiency than the case of using the transmissive phosphor film.

In this way, according to the present invention, as a result of manufacturing the reflective phosphor film by patterning the phosphor film and/or the glass film using the phosphor film green sheet and the glass film green sheet and increasing the aspect ratio of each pattern, it may be possible to enhance extraction efficiency of light to be discharged outward.

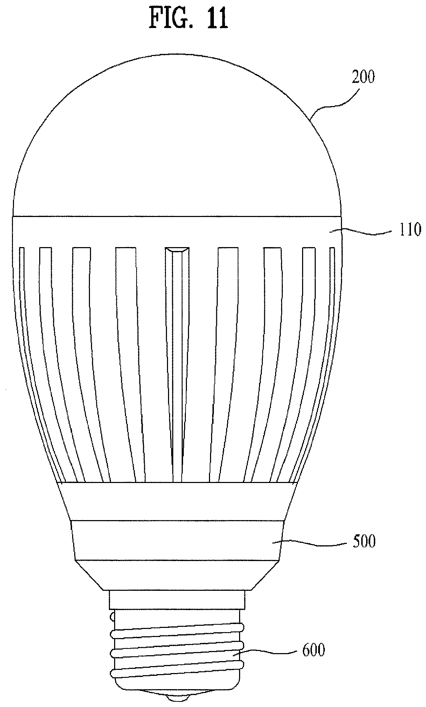

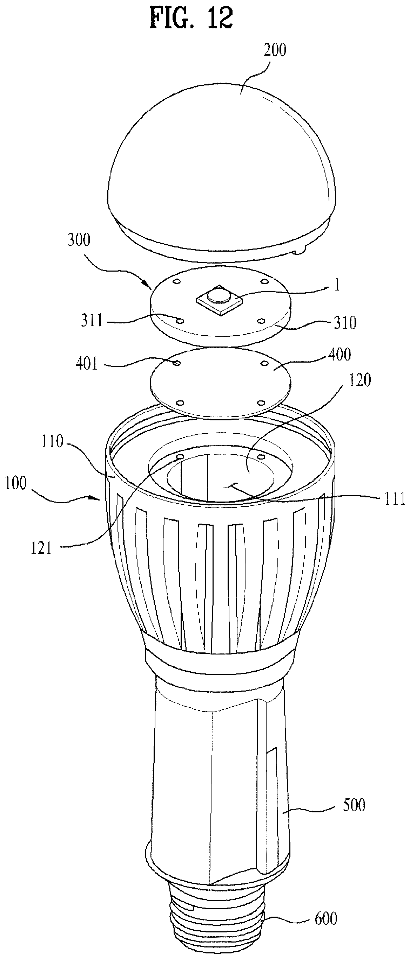

Hereinafter, a lighting apparatus using the light emitting device package will be described with reference to FIGs. 11 and 12.

FIG. 11 is a perspective view of a lighting apparatus, and FIG. 12 is an exploded perspective view of the lighting apparatus.

Referring to FIGs. 11 and 12, the lighting apparatus includes a heat sink 100, a lens unit 200, a light emitting unit 300, an electric unit (not shown), a case 500, and a power socket 600.

The heat sink 100 may include an outer housing 110 that defines an external appearance of the heat sink 100 and has a hollowed portion 111, and an inner housing 120 that is placed in the hollowed portion 111 and extends longitudinally.

The outer housing 110 may be formed of a light and highly thermally conductive material to outwardly radiate heat generated from the light emitting unit 300 during actuation of the lighting apparatus. The outer housing 110 may be formed of a resin material.

The hollowed portion 111 is perforated in a longitudinal direction of the outer housing 110. For example, the hollowed portion 111 may take the form of a cylinder. The inner housing 120, the electric unit, and the case 500, for example, may be inserted into the hollowed portion 111.

The inner housing 120 is placed in the hollowed portion 111 of the outer housing 110. The inner housing 120 may be provided with a plurality of fins protruding toward the outer housing 110. The fins may increase a surface area of the inner housing 120 as well as a contact area between the inner housing 120 and the outer housing 110 so as to enhance radiation efficiency.

As such, heat generated from the light emitting unit 300 is transferred to the inner housing 120, and in turn the heat transferred to the inner housing 120 is discharged outward through the outer housing 110, whereby radiation of the lighting apparatus is accomplished.

The lens unit 200 is mounted to the outer housing 110. The lens unit 200 functions to outwardly guide light emitted from the light emitting unit 300 mounted to the housing 110 and may include at least one condenser lens.

The lens unit 200 may be manufactured by molding a diffuser made of a resin, such as polycarbonate, acryl or the like, into a bulb, in order to diffuse light emitted from the light emitting unit 300 for enhancement of light emission efficiency.

The light emitting unit 300 includes a board 310 and the light emitting device package 1 mounted on the board 310. The board 310 may be a printed circuit board. For example, the light emitting device package 1 may be attached to the printed circuit board via Surface Mount Technology (SMT).

The light emitting device package 1 may include the phosphor film manufactured by the above described method of FIGs. 1 to 3. In addition, the light emitting device package 1 may be the light emitting device package 1 as described above with reference to FIGs. 6 to 10. Thus, a detailed description thereof will be omitted hereinafter.

Alternatively, the light emitting unit 300 may be mounted to the inner housing 120. That is, the board 310 of the light emitting unit 300 may be fastened to the inner housing 120. To this end, the lighting apparatus may further include a fastener (not shown) that penetrates the board 310 of the light emitting unit 300 to thereby be fixed to the inner housing 120.

The fastener may be a screw. The board 310 may have a first fastening hole 311 perforated from a surface on which the light emitting diode package 1 is mounted to an opposite surface thereof. The inner housing 120 may have a second fastening hole 121 at a position corresponding to the first fastening hole 311.

Meanwhile, the lighting apparatus may further include a thermal conduction pad 400 placed between the light emitting unit 300 and the inner housing 120. If the thermal conduction pad 400 is placed between the light emitting unit 300 and the inner housing 120, the thermal conduction pad 400 may have a third fastening hole 401 at a position corresponding to the first fastening hole 311 of the board 310 and the second fastening hole 121 of the inner housing 120. As such, in the above described configuration, the light emitting unit 300 and the thermal conduction pad 400 may be fixed to the inner housing 120 using the above described fastener.

In this way, the thermal conduction pad 400 may enhance heat transfer performance between the light emitting unit 300 and the inner housing 120, and may increase a contact area between the light emitting unit 300 and the inner housing 120 so as to enhance radiation efficiency.

The electric unit (not shown) is placed in the hollowed portion 111 of the outer housing 110 and is electrically connected to the light emitting unit 300. The electric unit serves to supply power to the light emitting unit 300, and includes a circuit unit electrically connected to the light emitting unit 300 and an insulator filled in a space between the circuit and the case 500 to insulate the circuit unit.

The insulator filled in the space between the circuit unit and the case 500 may be formed of silicone.

The case 500 surrounds the electric unit and is inserted into the hollowed portion 111 of the outer housing 110. For example, a partial region of the case 500 may be inserted into the hollowed portion 111 of the outer housing 110 so as to be located inside the inner housing 120.

The case 500 and the hollowed portion 111 of the outer housing 110 may be respectively provided with structures to assist easy insertion of the case 500. In one example, a guide protrusion (not shown) may be provided at an outer peripheral surface of the case 500, and a guide groove (not shown) may be provided in an inner peripheral surface of the hollowed portion 111 of the outer housing 110 so as to guide insertion of the guide protrusion of the case 500.

The power socket 600 may be mounted to the case 500.

It will be apparent to those skilled in the art that various modifications and variations can be made in the present invention without departing from the scope of the invention. Thus, it is intended that the present invention covers the modifications and variations of this invention provided they come within the scope of the appended claims.

## Claims

1. A method of manufacturing a light emitting device package including a phosphor film, the method comprising:
attaching a phosphor film green sheet (40) on a first surface of a support substrate (30);
attaching a glass film green sheet (50) on the phosphor film green sheet;
patterning the glass film green sheet (50)
sintering the phosphor film green sheet and the glass film green sheet to form a phosphor film (41) and a glass film (51) wherein patterning the glass film green sheet (50) is performed by mold pressing so as to form a first pattern on the glass film green sheet (50) such that a top of the phosphor film green sheet (40) is also patterned so as to form a second pattern on the phosphor film green sheet (40).

2. The method according to claim 1, wherein the phosphor film green sheet (40) is formed by coating a film with a mixture of a glass powder, a phosphor powder, an organic binder, and a dispersing agent.

3. The method according to claim 2, wherein the phosphor film green sheet (40) includes an organic resin in a range of 12 wt% to 25 wt% and an inorganic solid in a range of 75 wt% to 88 wt%.

4. The method according to any of claim 1 or 3, wherein the aspect ratio of patterns of the glass film (51) and the phosphor film (41) is in a range of 2:1 to 6:1.

5. The method according to any one of claims 1 to 4, wherein the pattern comprises a hole pattern, a line pattern, a recessed pattern, or a ridged pattern.

6. The method according to any one of claims 1 to 5, further comprising forming a lens unit (60) on a second surface of the support substrate (30).

7. The method according to claim 6, wherein the lens unit (60) is located opposite the first pattern and the second pattern with respect to the support substrate (30).

8. The method according to claim 6, wherein the lens unit (60) is formed by applying polymer beads or a resin to the second surface of the support substrate (30).

9. A light emitting device package comprising:
a package body (10) having a mounting portion (11);
a light emitting device (20) mounted in the mounting portion;
a support substrate (30) located over the light emitting device;
a phosphor film (41) disposed on a first surface of the support substrate; and
a patterned glass film (51) disposed on the phosphor film,
**characterized in that**:
the top of the phosphor film (41) is patterned.

10. The package according to claim 9, wherein a pattern of the phosphor film (41) is equal to a pattern of the glass film (51).

11. The package according to claim 9, wherein a lens unit (60) is located on a second surface of the support substrate (30).

12. The package according to claim 9 or 11, wherein the lens unit (60) comprises an array of a plurality of lenses or a single lens located at the center of the support substrate.

13. The package according to any one of claims 9 to 12, wherein the aspect ratio of a pattern of the glass film (51) is in a range of 2:1 to 6:1.

14. The package according to any one of claims 9 to 13, wherein the pattern comprises a hole pattern, a line pattern, a recessed pattern, or a ridged pattern.

## Patentansprüche

1. Verfahren zum Herstellen einer lichtemittierenden Vorrichtungsbaugruppe mit einer Leuchtstoffschicht, wobei das Verfahren aufweist:
Anbringen einer Leuchtstoffschicht-Grünfolie (40) auf einer ersten Oberfläche eines Trägersubstrats (30);
Anbringen einer Glasschicht-Grünfolie (50) auf der Leuchtstoffschicht-Grünfolie;
Strukturieren der Glasschicht-Grünfolie (50);
Sintern der Leuchtstoffschicht-Grünfolie und der Glasschicht-Grünfolie, um eine Leuchtstoffschicht (41) und eine Glasschicht (51) zu bilden, wobei
das Strukturieren der Glasschicht-Grünfolie (50) mittels Formpressen so durchgeführt wird, dass eine erste Struktur auf der Glasschicht-Grünfolie (50) gebildet wird, so dass auch eine Oberseite der Leuchtstoffschicht-Grünfolie (40) strukturiert wird, um eine zweite Struktur auf der Leuchtstoffschicht-Grünfolie (40) zu bilden.

2. Verfahren nach Anspruch 1, wobei die Leuchtstoffschicht-Grünfolie (40) gebildet wird, indem eine Schicht mit einer Mischung aus Glaspulver, Phosphorpulver, einem organischen Bindemittel und einem Dispersionsmittel beschichtet wird.

3. Verfahren nach Anspruch 2, wobei die Leuchtstoffschicht-Grünfolie (40) ein organisches Harz im Bereich von 12 Gew.-% bis 25 Gew.-% und einen anorganischen Feststoff im Bereich von 75 Gew.-% bis 88 Gew.-% aufweist.

4. Verfahren nach einem der Ansprüche 1 oder 3, wobei das Strukturformverhältnis der Glasschicht (51) und der Leuchtstoffschicht (41) in einem Bereich von 2:1 bis 6:1 liegt.

5. Verfahren nach einem der Ansprüche 1 bis 4, wobei die Struktur ein Lochmuster, ein Linienmuster, ein Aussparungsmuster oder ein Rillenmuster umfasst.

6. Verfahren nach einem der Ansprüche 1 bis 5, ferner aufweisend das Ausbilden einer Linseneinheit (60) auf einer zweiten Oberfläche des Trägersubstrats (30).

7. Verfahren nach Anspruch 6, wobei die Linseneinheit (60) gegenüber der ersten Struktur und der zweiten Struktur bezüglich des Trägersubstrats (30) liegt.

8. Verfahren nach Anspruch 6, wobei die Linseneinheit (60) durch Anbringen von Polymerperlen oder eines Harzes auf die zweite Oberfläche des Trägersubstrats (30) gebildet wird.

9. Lichtemittierende Vorrichtungsbaugruppe aufweisend:
einen Baugruppenkörper (10) mit einem Befestigungselement (11);
eine im Befestigungsabschnitt angebrachte lichtemittierende Vorrichtung (20);
ein über der lichtemittierenden Vorrichtung gelegenes Trägersubstrat (30);
eine auf einer ersten Oberfläche des Trägersubstrats angebrachte Leuchtstoffschicht (41); und
eine auf der Leuchtstoffschicht angebrachte strukturierte Glasschicht (51),
**dadurch gekennzeichnet, dass**:
die Oberfläche der Leuchtstoffschicht (41) strukturiert ist.

10. Baugruppe nach Anspruch 9, wobei eine Struktur der Leuchtstoffschicht (41) einer Struktur der Glasschicht (51) entspricht.

11. Baugruppe nach Anspruch 9, wobei eine Linseneinheit (60) auf einer zweiten Oberfläche des Trägersubstrats (30) liegt.

12. Baugruppe nach Anspruch 9 oder 11, wobei die Linseneinheit (60) eine Reihe mehrerer Linsen oder eine einzige Linse in der Mitte des Trägersubstrats aufweist.

13. Baugruppe nach einem der Ansprüche 9 bis 12, wobei das Strukturformverhältnis der Glasschicht (51) im Bereich von 2:1 bis 6:1 liegt.

14. Baugruppe nach einem der Ansprüche 9 bis 13, wobei die Struktur ein Lochmuster, ein Linienmuster, ein Aussparungsmuster oder ein Rillenmuster umfasst.

## Revendications

1. Procédé de fabrication d'un module de dispositif électroluminescent incluant un film de phosphore, le procédé comprenant :
la fixation d'une feuille verte de film de phosphore (40) sur une première surface d'un substrat de support (30) ;
la fixation d'une feuille verte de film de verre (50) sur la feuille verte de film de phosphore ;
la formation d'un motif sur la feuille verte de film de verre (50) ;
le frittage de la feuille verte de film de phosphore et de la feuille verte de film de verre pour former un film de phosphore (41) et un film de verre (51) ;
dans lequel
la formation d'un motif sur la feuille verte de film de verre (50) est effectuée par pression en moule de manière à former un premier motif sur la feuille verte de film de verre (50) de telle sorte qu'une partie supérieure de la feuille verte de film de phosphore (40) soit également dotée d'un motif de manière à former un second motif sur la feuille verte de film de phosphore (40).

2. Procédé selon la revendication 1, dans lequel la feuille verte de film de phosphore (40) est formée par revêtement d'un film avec un mélange d'une poudre de verre, d'une poudre de phosphore, d'un liant organique et d'un agent de dispersion.

3. Procédé selon la revendication 2, dans lequel la feuille verte de film de phosphore (40) inclut une résine organique dans une plage de 12 % en poids à 25 % en poids et un solide inorganique dans une plage de 75 % en poids à 88 % en poids.

4. Procédé selon l'une quelconque des revendications 1 ou 3, dans lequel le rapport largeur/longueur des motifs du film de verre (51) et du film de phosphore (41) est dans une plage de 2:1 à 6:1.

5. Procédé selon l'une quelconque des revendications 1 à 4, dans lequel le motif comprend un motif de trou, un motif de ligne, un motif en retrait ou un motif nervuré.

6. Procédé selon l'une quelconque des revendications 1 à 5, comprenant en outre la formation d'une unité de lentille (60) sur une seconde surface du substrat de support (30).

7. Procédé selon la revendication 6, dans lequel l'unité de lentille (60) est située à l'opposé du premier motif et du second motif par rapport au substrat de support (30).

8. Procédé selon la revendication 6, dans lequel l'unité de lentille (60) est formée par application de billes de polymère ou d'une résine sur la seconde surface du substrat de support (30).

9. Module de dispositif électroluminescent comprenant :
un corps de module (10) ayant une partie de montage (11) ;
un dispositif électroluminescent (20) monté dans la partie de montage ;
un substrat de support (30) situé au-dessus du dispositif électroluminescent ;
un film de phosphore (41) disposé sur une première surface du substrat de support ;
et
un film de verre (51) à motif disposé sur le film de phosphore,
**caractérisé en ce que** :
la partie supérieure du film de phosphore (41) est dotée d'un motif.

10. Module selon la revendication 9, dans lequel un motif du film de phosphore (41) est égal à un motif du film de verre (51).

11. Module selon la revendication 9, dans lequel une unité de lentille (60) est située sur une seconde surface du substrat de support (30).

12. Module selon la revendication 9 ou 11, dans lequel l'unité de lentille (60) comprend un réseau d'une pluralité de lentilles ou une lentille unique située au centre du substrat de support.

13. Module selon l'une quelconque des revendications 9 à 12, dans lequel le rapport largeur/longueur d'un motif du film de verre (51) est dans une plage de 2:1 à 6:1.

14. Module selon l'une quelconque des revendications 9 à 13, dans lequel le motif comprend un motif de trou, un motif de ligne, un motif en retrait ou un motif nervuré.
